# EUROPEAN PATENT APPLICATION

(11) **EP 4 406 869 A1**
(43) Date of publication of application: **31.07.2024**
(21) Application number: 22872728.5
(22) Date of filing: 08.09.2022
(51) Int. Cl.: B65D 8/16, B65D 65/02, C09J 167/02, C09J 7/30, C08G 63/12, H05K 1/03

(54) **ADHESIVE RESIN COMPOSITION**

(30) Priority: 22.09.2021 JP 2021154071
(71) Applicant: TOYOBO MC Corporation, Osaka 530-0001 (JP)
(72) Inventor: MIEDA, Hiroyuki, Otsu-shi, Shiga 520-0292 (JP); SAKAMOTO, Koichi, Otsu-shi, Shiga 520-0292 (JP); MIKAMI, Tadahiko, Otsu-shi, Shiga 520-0292 (JP)
(74) Representative: Müller-Boré & Partner Patentanwälte PartG mbB
(86) International application number: PCT/JP2022/033788
(87) International publication number: WO 2023/047973

(57) **Abstract**

The adhesive resin composition according to the present invention is characterized by containing a polyester resin (A) and satisfying: (i) the polyester resin (A) has an acid value of 100 eq/ton or more; (ii) the polyester resin (A) contains, as polyol components constituting the polyester resin (A), a diol (a) having two primary hydroxy groups and having no alicyclic structure, and either one or both of a diol (b) having an alicyclic structure and a diol (c) having one primary hydroxy group and one secondary hydroxy group and having no alicyclic structure; and (iii) the polyester resin (A) contains, as polycarboxylic acid components constituting the polyester resin (A), an unsaturated dicarboxylic acid (d). The adhesive resin composition according to the present invention enables curing even if the adhesive resin composition contains substantially no curing agent and therefore has excellent properties such as high solder heat resistance and adhesiveness to various base materials. The present invention also provides a laminate or an adhesive sheet comprising an adhesive layer made from the adhesive resin composition, a printed-wiring board or a packing material comprising the laminate as a constituent element, and a laminated film for decorating three-dimensional molded article or a film for laminating metal can comprising the adhesive sheet as a constituent element.

## Description

### Technical Field

The present invention relates to an adhesive resin composition, a laminate or an adhesive sheet including an adhesive layer made from the adhesive resin composition, a printed-wiring board or a packing material comprising the laminate as a constituent element, and a laminated film for decorating three-dimensional molded article or a film for laminating metal can comprising the adhesive sheet as a constituent element.

### Background Art

Adhesive has been recently used in various fields. Due to diversified use purposes thereof, adhesive is required to have further higher performance, i.e., excellent adhesiveness to base materials such as various plastic films, metal, and glass epoxy, and heat resistance, compared with conventionally used adhesive. For example, an adhesive for circuit boards such as a flexible printed circuit (hereinafter, sometimes abbreviated as a "FPC") is required to have adhesiveness, processability, electric properties, and preservability. For this usage, an epoxy/acrylic butadiene-based adhesive, an epoxy/polyvinyl butyral-based adhesive, and the like are conventionally used.

Particularly, due to handling of lead-free solder and FPC use environment, an adhesive having higher solder heat resistance is recently being required. Also, due to high density of wiring, multi-layered FPC wiring boards, and operability, solder heat resistance is strongly being required. As a method for solving these problems, there is disclosed a resin composition for adhesive containing polyester-polyurethane and an epoxy resin as main components (Patent Document 1).

### Prior Art Document

### Patent Document

Patent Document 1: Japanese Patent Application Laid-Open (JP-A) No. 2008-205370

### Disclosure of the Invention

### Problem that the Invention is to Solve

The composition described in Patent Document 1, however, has not been able to sufficiently satisfy high heat resistance required for lead-free solder.

An object of the present invention is to provide an adhesive resin composition that enables curing of a polyester resin by itself even if the adhesive resin composition contains substantially no curing agent, and that has excellent solder heat resistance and adhesiveness to various base materials.

### Means for Solving the Problem

As a result of conducting earnest study to solve the problems described above, the inventors of the present invention have found that an adhesive resin composition having a prescribed amount of acid value and having a specific structure enables curing of a polyester resin by itself with use of substantially no curing agent. Further, the inventors have found that, by specifying the resin composition and controlling the amount of a catalyst, an adhesive resin composition having excellent balance between curing properties and adhesiveness to various base materials, and having high solder heat resistance that enables application of the adhesive resin composition to lead-free solder can be obtained. The inventors have thus arrived at the present invention.

Thus, the present invention comprises the following constitutions.
[1] An adhesive resin composition containing a polyester resin (A) and satisfying following requirements (i) to (iii).
   (i) The polyester resin (A) has an acid value of 100 eq/ton or more.
   (ii) The polyester resin (A) contains, as polyol components constituting the polyester resin (A), a diol (a) having two primary hydroxy groups and having no alicyclic structure, and either one or both of a diol (b) having an alicyclic structure and a diol (c) having one primary hydroxy group and one secondary hydroxy group and having no alicyclic structure.
   (iii) The polyester resin (A) contains, as polycarboxylic acid components constituting the polyester resin (A), an unsaturated dicarboxylic acid (d).
[2] The adhesive resin composition according to [1], wherein the polyester resin (A) has a branched structure.
[3] The adhesive resin composition according to [1] or [2], wherein the adhesive resin composition contains substantially no curing agent.
[4] The adhesive resin composition according to [1] or [2], wherein the polyester resin (A) contains, as polycarboxylic acid components constituting the polyester resin (A), a polycarboxylic acid having a benzene skeleton, and at least one member selected from the group consisting of an aliphatic polycarboxylic acid, an alicyclic polycarboxylic acid, and a polycarboxylic acid having a naphthalene skeleton.
[5] The adhesive resin composition according to [1] or [2], wherein the polyester resin (A) contains, as polycarboxylic acid components constituting the polyester resin (A), 5 to 20 mol% of the unsaturated dicarboxylic acid (d).
[6] The adhesive resin composition according to [1] or [2], wherein the adhesive resin composition further contains at least one catalyst (B).
[7] The adhesive resin composition according to [1] or [2], wherein the polyester resin (A) exhibits an amount of tetrahydrofuran-insoluble matter of less than 10 mass% when having undergone a heating treatment at 120°C for 15 minutes.
[8] A laminate comprising an adhesive layer made from the adhesive resin composition according to [1] or [2].
[9] An adhesive sheet comprising an adhesive layer made from the adhesive resin composition according to [1] or [2].
[10] A printed-wiring board comprising the laminate according to [8] as a constituent element.
[11] A packing material comprising the laminate according to [8] as a constituent element.
[12] A laminated film for decorating three-dimensional molded article comprising the adhesive sheet according to [9] as a constituent element.
[13] A film for laminating metal can comprising the adhesive sheet according to [9] as a constituent element.

### Effects of the Invention

The present invention can provide an adhesive resin composition that enables curing even if the adhesive resin composition contains substantially no curing agent and therefore has excellent properties such as high solder heat resistance and adhesiveness to various base materials. Mode for Carrying Out the Invention

As hereunder, an embodiment of the present invention will be explained in detail. The adhesive resin composition according to the present invention is an adhesive resin composition that contains a polyester resin (A) and that satisfies following requirements (i) to (iii).
(i) The polyester resin (A) has an acid value of 100 eq/ton or more.
(ii) The polyester resin (A) contains, as polyol components constituting the polyester resin (A), a diol (a) having two primary hydroxy groups and having no alicyclic structure, and either one or both of a diol (b) having an alicyclic structure and a diol (c) having one primary hydroxy group and one secondary hydroxy group and having no alicyclic structure.
(iii) The polyester resin (A) contains, as polycarboxylic acid components constituting the polyester resin (A), an unsaturated dicarboxylic acid (d).

### <Requirement (i)>

Requirement (i) defines that the acid value of polyester resin (A) is 100 eq/ton or more. The acid value is preferably 200 eq/ton or more, more preferably 250 eq/ton or more, and further preferably 300 eq/ton or more. When the polyester resin (A) has an acid value of less than the above lower limit value, the number of carboxyl groups which will act as crosslinking points can be sufficiently secured and therefore the curing properties are better. Further, when the polyester resin (A) has an acid value of less than the above lower limit value, a curing reaction in heating to 200°C easily proceeds more preferentially than a pyrolytic reaction and the adhesiveness and the solder heat resistance are improved. By having an acid value of the above lower limit value or more, the polyester resin (A) is easily formed into an aqueous dispersion. The upper limit value of the acid value of the polyester resin (A) is not particularly limited, but the polyester resin (A) preferably has an acid value of 1200 eq/ton or less so as to reduce unreacted portions of the acid components in an acid addition reaction and the amount of oligomers.

The acid value of the polyester resin (A) can be imparted by any method. Examples of a method for imparting an acid value include a method for adding and reacting a polycarboxylic anhydride in a late stage of polycondensation, and a method for forming a high-acid-value prepolymer (oligomer), and next subjecting the prepolymer to polycondensation so as to give a polyester resin having an acid value. Due to easiness of operation and easiness of obtaining a target acid value, the former adding and reacting method is preferable.

Among the compounds for imparting an acid value to the polyester resin (A) and having a polycarboxylic anhydride group in a molecule thereof, examples of a carboxylic monoanhydride include phthalic anhydride, succinic anhydride, maleic anhydride, trimellitic anhydride, itaconic anhydride, citraconic anhydride, 5-(2,5-dioxotetrahydrofurfuryl)-3-cyclohexene-1,2-dicarboxylic monoanhydride, hexahydrophthalic anhydride, and tetrahydrophthalic anhydride. At least one compound can be selected from among these examples and used. Among these examples, trimellitic anhydride is preferable from the aspect of versatility and economic efficiency.

Among the compounds for imparting an acid value to the polyester resin (A) and having a polycarboxylic anhydride group in a molecule thereof, examples of a carboxylic polyanhydride include pyromellitic anhydride, 1,2,3,4-butanetetracarboxylic dianhydride, 1,2,3,4-pentanetetracarboxylic dianhydride, 3,3',4,4'-benzophenonetetracarboxylic dianhydride, cyclopentanetetracarboxylic dianhydride, 2,3,6,7-naphthalenetetracarboxylic dianhydride, 1,2,5,6-naphthalenetetracarboxylic dianhydride, ethylene glycol bistrimellitate dianhydride, 2,2',3,3'-diphenyltetracarboxylic dianhydride, thiophene-2,3,4,5-tetracarboxylic dianhydride, ethylenetetracarboxylic dianhydride, 4,4'-oxydiphthalic dianhydride, and 5-(2,5-dioxotetrahydro-3-furanyl)-3-methyl-3-cyclohexene-1,2-dicarboxylic anhydride. At least one compound can be selected from among these examples and used. Among these examples, ethylene glycol bistrimellitate dianhydride is preferable.

As to the compounds for imparting an acid value and having a polycarboxylic anhydride group in a molecule thereof, a carboxylic monoanhydride and carboxylic polyanhydride can be used singly or in combination.

### <Requirement (ii)>

Requirement (ii) defines that the polyester resin (A) according to the present invention contains, as polyol components constituting the polyester resin (A), a diol (a) having two primary hydroxy groups and having no alicyclic structure, and either one or both of a diol (b) having an alicyclic structure and a diol (c) having one primary hydroxy group and one secondary hydroxy group and having no alicyclic structure (hereinafter, each of components sometimes called a "component (a)", a "component (b)", or a "component (c)"). The component (a) easily forms an ester bond, whereas the components (b) and (c) more easily cause cleavage of an ester bond than the component (a). Therefore, when the polyester resin (A) contains the component (a) and the component (b) and/or (c), rearrangement and recombination of ester bonds are promoted during a heating treatment, causing good curing properties, and resulting in improvement of the adhesiveness and the solder heat resistance.

Examples of the diol (a) contained in the polyester resin (A), and having two primary hydroxy groups and having no alicyclic structure include: aliphatic glycols such as ethylene glycol, 1,3-propanediol, 2-butyl-2-ethyl-1,3-propanediol, 2-methyl-1,3-propanediol, neopentyl glycol, 3-methyl-1,5-pentanediol, 1,4-butanediol, 2,4-diethyl-1,5-pentanediol, 1,6-hexanediol, 2-methyl-1,8-octanediol, 3-methyl-1,6-hexanediol, 4-methyl-1,7-heptanediol, 4-methyl-1,8-octanediol, and 1,9-nonanediol; and polyether glycols such as diethylene glycol, triethylene glycol, polyethylene glycol, polypropylene glycol, and polytetramethylene glycol. At least one compound can be selected from among these examples and used. Among these examples, ethylene glycol, 2-methyl-1,3-propanediol, and 1,6-hexanediol are preferably used.

The copolymerization proportion of the diol (a) contained in the polyester resin (A), and having two primary hydroxy groups and having no alicyclic structure is preferably 20 to 80 mol%, more preferably 20 to 60 mol%, and further more preferably 20 to 40 mol%, in the total polyol components. When the copolymerization proportion is in the above range, the curing properties and the solder heat resistance are good.

The polyester resin (A) preferably contains, as a polyol component, a diol (b) having an alicyclic structure. When the polyester resin (A) contains the diol (b) having an alicyclic structure, both the adhesiveness and the solder heat resistance are easily achieved. Examples of the diol (b) constituting the polyester resin (A) and having an alicyclic structure include 1,2-cyclohexanedimethanol, 1,3-cyclohexanedimethanol, 1,4-cyclohexanedimethanol, a tricyclodecane glycol, and a hydrogenated bisphenol. At least one compound can be selected from among these examples and used. Among these examples, 1,4-cyclohexanedimethanol is preferably used from the aspect of the curing properties, the adhesiveness, and the solder heat resistance.

The copolymerization proportion of the diol (b) constituting the polyester resin (A) and having an alicyclic structure is preferably 5 to 50 mol%, more preferably 10 to 40 mol%, and further more preferably 20 to 30 mol%, in the total polyol components. When the copolymerization proportion is in the above range, the adhesiveness is good.

The polyester resin (A) preferably contains, as a polyol component, a diol (c) having one primary hydroxy group and one secondary hydroxy group and having no alicyclic structure. Examples of the diol (c) contained in the polyester resin (A), and having one primary hydroxy group and one secondary hydroxy group and having no alicyclic structure include 1,2-propylene glycol and 1,2-butanediol. At least one compound can be selected from among these examples and used. Among these examples, 1,2-propylene glycol is preferably used.

The copolymerization proportion of the diol (c) contained in the polyester resin (A), and having one primary hydroxy group and one secondary hydroxy group and having no alicyclic structure is preferably 5 to 75 mol%, more preferably 10 to 65 mol%, and further more preferably 15 to 50 mol%, in the total polyol components. When the copolymerization proportion is in the above range, the curing properties and the solder heat resistance are good.

### <Requirement (iii)>

Requirement (iii) defines that the polyester resin (A) contains, as polycarboxylic acid components constituting the polyester resin (A), an unsaturated dicarboxylic acid (d). When the polyester resin (A) contains the unsaturated dicarboxylic acid (d), the curing properties and the solder heat resistance can be improved due to a reaction of generating an intermolecular carbon-carbon bond caused by cleavage of an unsaturated bond during a heating treatment. Examples of the unsaturated dicarboxylic acid (d) include fumaric acid, maleic acid, itaconic acid, citraconic acid, 2,5-norbornanedicarboxylic acid, tetrahydrophthalic acid, and acid anhydrides thereof. At least one compound can be selected from among these examples and used.

The copolymerization proportion of unsaturated dicarboxylic acid (d) is preferably 5 to 20 mol%, and more preferably 10 to 15 mol%, in the polycarboxylic acid components. When the copolymerization proportion is in the above range, both the adhesiveness and the solder heat resistance can be achieved.

The polycarboxylic acid component constituting the polyester resin (A) is not particularly limited, and examples of the polycarboxylic acid component include: polycarboxylic acids having a benzene skeleton, such as terephthalic acid, isophthalic acid, and orthophthalic acid; and polycarboxylic acids having a naphthalene skeleton, such as 2,6-naphthalenedicarboxylic acid, 1,4-naphthalenedicarboxylic acid, and 1,8-naphthalenedicarboxylic acid. These polycarboxylic acids can be used singly or in combination of two or more thereof. Among these examples, a polycarboxylic acid having a benzene skeleton and a polycarboxylic acid having a naphthalene skeleton are preferably used in combination from the aspect of achieving both the adhesiveness and the solder heat resistance. When a polycarboxylic acid having a benzene skeleton and a polycarboxylic acid having a naphthalene skeleton are used in combination, the use ratio (mole ratio) between the polycarboxylic acid having a benzene skeleton and the polycarboxylic acid having a naphthalene skeleton is preferably 95/5 to 70/30, and more preferably 90/10 to 75/25. When the use ratio is in the above range, the adhesiveness and the solder heat resistance are better and the polyester resin (A) having such a ratio is thus preferable. As to a polycarboxylic acid having a benzene skeleton, terephthalic acid is preferable. As to a polycarboxylic acid having a naphthalene skeleton, 2,6-naphthalenedicarboxylic acid is preferable.

Examples of other polycarboxylic acid component constituting the polyester resin (A) include an aliphatic polycarboxylic acid component and an alicyclic polycarboxylic acid component. Examples of the aliphatic polycarboxylic acid component include succinic acid, glutaric, adipic acid, azelaic acid, sebacic acid, dodecanedioic acid, and dimer acid. Examples of the alicyclic polycarboxylic acid component include 1,4-cyclohexanedicarboxylic acid, tetrahydrophthalic acid, hexahydroisophthalic acid, and 1,2-cyclohexenedicarboxylic acid. At least one compound can be selected from among these examples and used. When the polyester resin (A) contains an aliphatic polycarboxylic acid component or an alicyclic polycarboxylic acid component, the adhesiveness can be improved. Among these examples, adipic acid and 1,4-cyclohexanedicarboxylic acid are preferable from the aspect of reactivity and economic efficiency.

When the polyester resin (A) contains, as constituent units, an aliphatic dicarboxylic acid component and an alicyclic dicarboxylic acid component, the copolymerization proportion thereof is preferably 5 to 40 mol%, and more preferably 15 to 35 mol%, in the polycarboxylic acid components. When the copolymerization proportion is out of the above range, the glass transition temperature of the polyester resin (A) is greatly decreased and the solder heat resistance is sometimes decreased.

The polyester resin (A) preferably has a branched structure. Having a branched structure refers to having a branched structure in the main chain of polyester. For introducing a branched structure into the polyester resin (A), there is, for example, a method for copolymerizing a trifunctional or higher-functional component as part of the polycarboxylic acid component and/or the polyol component in a polycondensation reaction of polyester. Examples of a trifunctional or higher-functional polycarboxylic acid component include trimellitic acid, pyromellitic acid, and benzophenonetetracarboxylic acid. Examples of a trifunctional or higher-functional polyol include glycerine, trimethylolethane, trimethylolpropane, mannitol, sorbitol, pentaerythritol, and α-methylglucoside. When the polyester resin (A) has a branched structure, the crosslinking density at a time of rearrangement and recombination of ester bonds during a heating treatment is increased, resulting in a rise of the THF-insoluble matter, and therefore the curing properties, the solder heat resistance, and the adhesiveness can be improved.

The copolymerization proportion of the trifunctional or higher-functional polycarboxylic acid component is preferably 0.1 mol% or more, more preferably 0.5 mol% or more, and further more preferably 1 mol% or more, to the total polycarboxylic acid components defined as 100 mol%. The copolymerization proportion of the trifunctional or higher-functional polycarboxylic acid component is preferably 7 mol% or less, more preferably 6 mol% or less, further more preferably 5 mol% or less, and particularly preferably 4 mol% or less, to the total polycarboxylic acid components defined as 100 mol%. The copolymerization proportion of the trifunctional or higher-functional polyol component is preferably 0.1 mol% or more, more preferably 0.5 mol% or more, and further more preferably 1 mol% or more, to the total polyol components defined as 100 mol%. The copolymerization proportion of the trifunctional or higher-functional polyol component is preferably 5 mol% or less, more preferably 3 mol% or less, further more preferably 2 mol% or less, and particularly preferably 1 mol% or less, to the total polyol components defined as 100 mol%. When the copolymerization proportions of the trifunctional or higher-functional polycarboxylic acid component and the trifunctional or higher-functional polyol component are each more than the above range, flexibility of the polyester resin is lost, resulting in a decrease of adhesiveness or gelation generated during polymerization of polyester.

As to the polycarboxylic acid component and the polyol component that constitute the polyester resin (A), a raw material induced from a biomass resource can be used. The biomass resource includes, for example: something in the form of starch, cellulose, or the like into which sunlight energy is converted by plant photosynthesis and which stores the sunlight energy; animals that grow by eating plants; and products obtained by processing plants and animals. More preferred among these biomass resources is a plant resource, and examples of the plant resource include wood, rice straw, rice hull, rice bran, old rice, corn, sugar cane, cassava, sago palms, tofu refuse, corn cobs, tapioca refuse, bagasse, vegetable oil refuse, potatoes, buckwheat, soybeans, oils and fats, waste paper, papermaking residues, marine product residues, livestock wastes, sludge, and food wastes. Corn, sugar cane, cassava, and sago palms are more preferable.

Next, a method for producing the polyester resin (A) is described. In an esterification/exchange reaction, all the monomer components and/or low polymers thereof are heated and melted, and thus reacted. The esterification/exchange temperature is preferably 180 to 250°C, and more preferably 200 to 250°C. The reaction time is preferably 1.5 to 10 hours, and more preferably 3 to 6 hours. The reaction time is a time from reaching a desired reaction temperature until the following polycondensation reaction. In the polycondensation reaction, a polyol component is distilled away under reduced pressure at a temperature of 220 to 280°C from an esterified product obtained by the esterification reaction, and the polycondensation reaction is progressed until reaching a desired molecular weight. The polycondensation reaction temperature is preferably 220 to 280°C, and more preferably 240 to 275°C. The degree of decompression is preferably 130 Pa or less. An insufficient degree of decompression tends to prolong the polycondensation time and is therefore not preferable. The pressure is preferred to be gradually reduced over 30 to 180 minutes that are the decompression time from atmospheric pressure to reaching 130 Pa or less.

In the esterification/exchange reaction and the polycondensation reaction, polymerization is performed using as necessary an organic titanate compound such as tetrabutyl titanate, germanium dioxide, antimony oxide, and an organic tin compound such as tin octylate. An organic titanate compound is preferable from the aspect of reaction activity, and germanium dioxide is preferable from the aspect of coloring of resin.

The polyester resin (A) has a glass transition temperature of preferably 5 to 50°C, and more preferably 10 to 40°C, in terms of solder heat resistance and adhesiveness. When the polyester resin (A) has a glass transition temperature in the above range, the solder heat resistance and the adhesiveness to a base material are better.

The polyester resin (A) has a reduced viscosity of preferably 0.2 to 0.6 dl/g, and more preferably 0.3 to 0.5 dl/g. When the polyester resin (A) has a reduced viscosity of the above lower limit value or more, the adhesiveness to a base material is better due to aggregation force of resin. On the other hand, when the polyester resin (A) has a reduced viscosity of the above upper limit value or less, the melt viscosity and the solution viscosity are appropriate, resulting in good operability. In addition, the number of terminal hydroxy groups can be increased and an acid value is easily sufficiently imparted.

The adhesive resin composition according to the present invention preferably contains substantially no curing agent. The phrase "contains substantially no curing agent" means that "the content of a curing agent is less than 1 part by mass (in terms of solid content) relative to 100 parts by mass (in terms of solid content) of the polyester resin (A)". The adhesive resin composition according to the present invention can be cured due to self-crosslinking by heating even if it contains substantially no curing agent.

Here, the curing agent refers to any known curing agent that reacts with the polyester resin (A) of the present invention and thus forms a crosslinking structure. Examples of a form of the crosslinking structure include: a reaction of generating an intermolecular carbon-carbon bond by reacting an unsaturated double bond in the polyester resin through a radical addition reaction, a cationic addition reaction, an anionic addition reaction, or the like; and formation of an intermolecular bond through a condensation reaction, a polyaddition reaction, a transesterification reaction, or the like with a polyvalent carboxylic acid group or a polyhydric alcohol group in the polyester resin. Examples of the curing agent include a phenolic resin, an amino resin, an isocyanate compound, an epoxy compound, a β-hydroxylamide compound, and an unsaturated bond-containing resin.

The content of the curing agent in the adhesive resin composition according to the present invention is preferably less than 1 part by mass relative to 100 parts by mass (solid content) of the polyester resin (A). The content is more preferably less than 0.5 part by mass, and further more preferably less than 0.1 part by mass, and most preferably no curing agent is contained. When the content of the curing agent is more than the above range, the pot life property is poor. In addition, not only the economic efficiency is poor, but also the adhesiveness may possibly be decreased due to a self condensation reaction of the curing agent.

As described above, the adhesive resin composition according to the present invention can be cured due to self-crosslinking by heating treatment even if it contains substantially no curing agent.

The adhesive resin composition according to the present invention is preferred to exhibit an amount of tetrahydrofuran-insoluble matter of 10 mass% or more when having undergone a heating treatment at 200°C for 1 hour. As described above, the adhesive resin composition according to the present invention undergoes self-crosslinking by heating. The amount of tetrahydrofuran-insoluble matter at a time of a heating treatment is an index of the degree of self-crosslinking properties by this heating. When the amount of tetrahydrofuran (THF)-insoluble matter is 10 mass% or more, it is possible to obtain the adhesive resin composition having sufficient curing properties and excellent balance between solder heat resistance and adhesiveness, and an adhesive layer of the adhesive resin composition. Here, the adhesive layer refers to a layer of the adhesive resin composition according to the present invention that has been applied to a base material and dried. The amount of THF-insoluble matter is preferably 30 mass% or more, more preferably 50 mass% or more, and further more preferably 70 mass% or more. The adhesive resin composition exhibiting an amount of tetrahydrofuran-insoluble matter of less than 10 mass% has insufficient curing properties and may possibly have decreased adhesiveness and solder heat resistance. The amount of tetrahydrofuran-insoluble matter at a time of a heating treatment (degree of self-crosslinking properties by heating) is controllable by a conventionally known method, and can be controlled, for example, by adjusting the types or blending ratio of constituent components of the polyester resin (A) or by blending a catalyst.

Here, the phrase "exhibits an amount of tetrahydrofuran-insoluble matter of 10 mass% or more when having undergone a heating treatment at 200°C for 1 hour" means that the amount of THF-insoluble matter obtained by the following equation is 10 mass% or more. In the equation, (X) represents the mass (before immersion in THF) of a sample obtained by applying the adhesive resin composition onto a copper foil, such that the thickness after drying is 10 µm, performing heating at 200°C for 1 hour, and cutting the laminate in the size of length 10 cm and width 2.5 cm, and (Y) represents the mass (after immersion in THF) of the sample having been immersed in 60 ml of THF at 25°C for 1 hour, and then dried at 100°C for 10 minutes. THF-insoluble matter (mass%) = [{(Y) - (mass of copper foil)}/{(X) - (mass of copper foil)}] × 100

On the other hand, before the heating treatment, it is preferable that as little cured product as possible be contained from the viewpoint of handling such as solvent solubility and resin aggregation. The content of such cured product can be estimated by using the tetrahydrofuran (THF)-insoluble matter at a time of a heating treatment at low temperature as an index. Specifically, the polyester resin (A) used in the present invention preferably exhibits an amount of THF-insoluble matter of less than 10 mass% when having undergone a heating treatment at 120°C for 15 minutes. The amount of THF-insoluble matter is preferably less than 5 mass%, more preferably less than 1 mass%, and may be even 0 mass%. The polyester resin (A) exhibiting an amount of THF-insoluble matter of less than the above value when having undergone a heating treatment under the heating conditions of a relatively low temperature of around 120°C can suppress generation of aggregates at a time of being dissolved in a solvent or formed into an aqueous dispersion.

Here, the phrase "exhibits an amount of tetrahydrofuran-insoluble matter of less than 10 mass% when having undergone a heating treatment at 120°C for 15 minutes" means that the amount of THF-insoluble matter obtained by the following equation is less than 10 mass%. In the equation, (X) represents the mass (before immersion in THF) of a sample obtained by applying the polyester resin onto a copper foil, such that the thickness after drying is 10 µm, performing heating at 120°C for 15 minutes, and cutting the laminate in the size of length 10 cm and width 2.5 cm, and (Y) represents the mass (after immersion in THF) of the sample having been immersed in 60 ml of THF at 25°C for 1 hour, and then dried at 100°C for 10 minutes. THF-insoluble matter (mass%) = [{(Y) - (mass of copper foil)}/{(X) - (mass of copper foil)}] × 100

### [Catalyst (B)]

The adhesive resin composition according to the present invention preferably further contains a catalyst (B). When the polyester resin composition contains the catalyst (B), the self crosslinking properties of the polyester resin (A) during a heating treatment is promoted, resulting in a rise of the storage elastic modulus E' and enabling an improvement of the performance of the cured film. Examples of the catalyst include: acid catalysts such as sulfuric acid, p-toluenesulfonic acid, dodecylbenzenesulfonic acid, naphthalenesulfonic acid, dinonylnaphthalenesulfonic acid, dinonylnaphthalenedisulfonic acid, camphorsulfonic acid, and phosphoric acid, and amine-blocked products thereof (partially neutralized products thereof obtained by adding an amine); organic tin compounds such as dibutyltin dilaurate; titanium compounds such as titanium tetrabutoxide; zinc compounds such as zinc acetate; hafnium compounds such as a hafnium chloride THF complex; and rare earth compounds such as scandium triflate. One or two or more in combination can be used from these examples. Among these examples, dodecylbenzenesulfonic acid and a neutralized product thereof are preferable from the aspect of compatibility with the polyester resin (A) and sanitation.

The blending ratio (A)/(B) between the polyester resin (A) and the catalyst (B) used in the adhesive resin composition according to the present invention is preferably 100/0.01 to 0.5 (parts by mass), more preferably 100/0.05 to 0.4 (parts by mass), and most preferably 100/0.1 to 0.3 (parts by mass). When the blending ratio is in the above range, the THF-insoluble matter of the adhesive resin composition after having undergone a heating treatment at 200°C for 1 hour can be increased.

In the adhesive resin composition according to the present invention, the catalyst (B) may be contained in the polyester resin (A) or may be added later. The catalyst (B) is preferably added after the production of the polyester resin (A) from the viewpoint of avoiding gelation during polymerization of the polyester resin (A).

The adhesive resin composition according to the present invention may have a radical polymerization inhibitor (C) added thereto. The radical polymerization inhibitor (C) is used mainly for preventing gelation caused by cleavage of unsaturated bonds at a time of polymerizing the polyester resin (A), but may also be added after the polymerization so as to increase the storage stability of the polyester resin (A). Examples of the radical polymerization inhibitor (C) include known radical polymerization inhibitors such as a phenolic antioxidant, a phosphorus-based antioxidant, an amine-based antioxidant, a sulfur-based antioxidant, a nitro compound-based antioxidant, and inorganic compound-based antioxidant.

Examples of the phenolic antioxidant include 2,5-di-t-butylhydroquinone, 4,4'-butylidenbis(3-methyl-6-t-butylphenol), 1,1,3-tris(2-methyl-4-hydroxy-5-t-butylphenyl)butane, 1,3,5-tris-methyl-2,4,6-tris(3,5-di-t-butyl-4-hydroxybenzyl)benzene, and tris(3,5-di-t-butyl-4-hydroxyphenyl)isocyanurate, and derivatives thereof.

Examples of the phosphorus-based antioxidant include tri(nonylphenyl) phosphite, triphenyl phosphite, diphenylisodecyl phosphite, trioctadecyl phosphite, tridecyl phosphite, diphenyldecyl phosphite, 4,4'-butylidene-bis(3-methyl-6-t-butylphenyl ditridecyl phosphite), distearyl-pentaerythritol diphosphite, and trilauryl trithiophosphite, and derivatives thereof.

Examples of the amine-based antioxidant include phenyl-beta-naphthylamine, phenothiazine, N,N'-diphenyl-p-phenylenediamine, N,N'-di-betanaphthyl-p-phenylenediamine, N-cyclohexyl-N'-phenyl-p-phenylenediamine, aldol-alpha-naphthylamine, and a 2,2,4-trimethyl-1,2-dihydroquinoline polymer, and derivatives thereof.

Examples of the sulfur-based antioxidant include thiobis(N-phenyl)-beta-naphthylamine, 2-mercaptobenzothiazole, 2-mercaptobenzimidazole, tetramethylthiuram disulfide, and nickel isopropyl xanthate, and derivatives thereof.

Examples of the nitro compound-based antioxidant include 1,3,5-trinitrobenzene, p-nitrosodiphenylamine, p-nitrosodimethylanilin, 1-chloro-3-nitrobenzene, o-dinitrobenzene, m-dinitrobenzene, p-dinitrobenzene, p-nitrobenzoic acid, nitrobenzene, and 2-nitro-5-cyanothiophene, and derivatives thereof.

Examples of the inorganic compound-based antioxidant include: FeCl₃, Fe(CN)₃, CuCl₂, CoCl₃, Co(ClO₄)₃, Co(NO₃)₃, and Co₂(SO₄)₃.

Among the antioxidants described above, the radical polymerization inhibitor (C) is preferably a phenolic antioxidant and an amine-based antioxidant in terms of thermal stability, and those having a melting point of 120°C or more and a molecular weight of 200 or more are more preferable, and those having a melting point of 170°C or more are further more preferable. More preferable are specifically phenothiazine, 4,4'-butylidenbis(3-methyl-6-t-butylphenol), and the like.

The blending ratio (A)/(C) between the polyester resin (A) and the radical polymerization inhibitor (C) used in the adhesive resin composition according to the present invention is preferably 100/0.001 to 0.5 (parts by mass), more preferably 100/0.01 to 0.1 (parts by mass), and most preferably 100/0.02 to 0.08 (parts by mass). When the blending ratio is in the above range, gelation during the production of the polyester resin (A) can be suppressed.

The adhesive resin composition according to the present invention may further contain other component as necessary according to the required properties. Specific examples of such a component that can be blended include a flame retardant, a tackifier, a silane coupling agent, known inorganic fillers such as titanium oxide and silica, phosphoric acid and an esterified product thereof, and known additives such as a surface smoothing agent, a defoamer, a dispersant, and a lubricant. Blending of particularly a filler such as silica improves the properties of solder heat resistance and therefore is very preferable. Generally known as the silica are hydrophobic silica and hydrophilic silica. Here, hydrophobic silica is better that has been treated with dimethyl dichlorosilane, hexamethyl disilazane, octylsilane, or the like so as to impart moisture absorption resistance. When silica is blended, the blending amount thereof is preferably 0.05 to 30 parts by mass relative to 100 parts by mass of the polyester resin (A). When the blending amount is the above lower limit value or more, the adhesive resin composition can exhibit an effect of improving the solder heat resistance. When the blending amount is the upper limit value or less, no dispersion failure of silica is generated and thus the solution viscosity is good, resulting in good operability. In addition, the adhesiveness is not decreased.

The adhesive resin composition according to the present invention can be dissolved in a known organic solvent. Examples of the organic solvent include toluene, xylene, ethyl acetate, butyl acetate, methyl ethyl ketone, methyl isobutyl ketone, cyclohexanone, isophorone, methyl cellosolve, butyl cellosolve, ethylene glycol monoethyl ether acetate, diethylene glycol monoethyl ether acetate, ethylene glycol monoacetate, methanol, ethanol, butanol, ethylene glycol monoethyl ether, ethylene glycol monobutyl ether, diethylene glycol monobutyl ether, and Solvesso. At least one compound is selected from among these examples and used in consideration of solubility, evaporation rate, and the like.

The adhesive resin composition according to the present invention can also have blended thereto other resin for the purpose of modification such as imparting of flexibility and adhesion of the adhesive layer. Examples of the other resin include amorphous polyester, crystalline polyester, an ethylene-polymerizable unsaturated carboxylic acid copolymer, and an ethylene-polymerizable carboxylic acid copolymer ionomer. By blending at least one resin selected from these examples, the flexibility and/or the adhesion of the coating film can sometimes be imparted.

The adhesive resin composition according to the present invention can be applied to a base material and then dried to form an adhesive layer. The base material is not particularly limited, and examples of the base material include resin base materials such as a film-shaped resin, metal base materials such as a metal plate and a metal foil, and paper.

Examples of the resin base material include a polyester resin, a polyamide resin, a polyimide resin, a polyamideimide resin, a liquid crystal polymer, polyphenylene sulfide, syndiotactic polystyrene, a polyolefin-based resin, and a fluorine-based resin. Preferred is a film-shaped resin (hereinafter, also called a base-material film layer).

As to the metal base material, any conventionally known conductive material usable for circuit boards can be used. Examples of the material include various metals such as SUS, copper, aluminum, iron, steel, zinc, and nickel, and alloys thereof, plated products, and metals treated with another metal such as zinc and a chromium compound. Preferred is a metal foil, and more preferred is a copper foil. The thickness of the metal foil is not particularly limited, but is preferably 1 um or more, more preferably 3 um or more, and further more preferably 10 um or more. The thickness of the metal foil is preferably 50 um or less, more preferably 30 um or less, and further more preferably 20 um or less. When the thickness is excessively small, it is sometimes difficult to obtain sufficient electric performance of the circuit. On the other hand, when the thickness is excessively large, the processing efficiency and the like in the preparation of a circuit is sometimes decreased. The metal foil is usually provided in the form of a roll. The form of the metal foil used to produce a printed-wiring board according to the present invention is not particularly limited. When the metal foil in the shape of a ribbon is used, the length of the metal foil is not particularly limited. The width of the metal foil is not particularly limited either, but is preferably around 250 to 500 cm.

Examples of the paper include high-quality paper, kraft paper, roll paper, and glassine paper. Examples of a composite material include glass epoxy.

From the aspect of adhesive force to the adhesive resin composition according to the present invention and durability, the base material is preferably a polyester resin, a polyamide resin, a polyimide resin, a polyamideimide resin, a liquid crystal polymer, polyphenylene sulfide, syndiotactic polystyrene, a polyolefin-based resin, a fluorine-based resin, a SUS steel sheet, a copper foil, an aluminum foil, or glass epoxy.

The laminate according to the present invention is one obtained by stacking the adhesive resin composition on a base material (two-layer laminate of base material/adhesive layer), or one obtained by further bonding a base material with the laminate (three-layer laminate of base material/adhesive layer/base material). The laminate according to the present invention can be obtained by applying the adhesive resin composition according to the present invention to any one of various base materials and drying the composition according to an ordinary method, and further stacking another base material.

The adhesive sheet according to the present invention is one obtained by stacking the laminate and a releasable base material one on top of another, with the adhesive resin composition interposed therebetween. Examples of a specific structure include a structure of laminate/adhesive layer/releasable base material, and a structure of releasable base material/adhesive layer/laminate/adhesive layer/releasable base material. The stacked releasable base material functions as a base-material protective layer. The use of a releasable base material enables the releasable base material to be released from the adhesive sheet and the adhesive layer to be transferred to another base material.

The adhesive sheet according to the present invention can be obtained by applying the adhesive resin composition according to the present invention to any one of various laminates and drying the composition according to an ordinary method. Bonding a releasable base material with the adhesive layer after the drying enables winding of the adhesive sheet without offset on the base material, resulting in excellent operability, and protects the adhesive layer, resulting in excellent preservability, and facilitates the use. In addition, when the adhesive resin composition is applied to a releasable base material, dried, and then bonded with another releasable base material as necessary, the adhesive layer itself can be transferred to another base material.

The releasable base material is not particularly limited, and examples of the releasable base material include those obtained by disposing an application layer of a sealer, such as clay, polyethylene, and polypropylene, on both surfaces of paper such as high-quality paper, kraft paper, roll paper, and glassine paper, and further applying a silicone-based, fluorine-based, or alkyd-based release agent onto the application layer. Examples of the releasable base material also include those obtained by applying the release agent described above onto any one of single olefin films such as polyethylene, polypropylene, an ethylene-α-olefin copolymer, and a propylene-α-olefin copolymer or onto a film such as polyethylene terephthalate. Due to reasons of release force of the releasable base material from the adhesive layer, adverse effects of silicone on electric properties, and the like, preferred are a releasable base material comprising an alkyd-based release agent on both surfaces of high-quality paper treated with a polypropylene sealer, or a releasable base material comprising an alkyd-based release agent on polyethylene terephthalate.

The method for coating the surface of a base material with the adhesive resin composition is not particularly limited in the present invention, and examples of the method include a comma coater and a reverse roll coater. Alternatively, the adhesive layer can as necessary be disposed directly or by a transfer method on a rolled copper foil or a polyimide film as a constituent material of a printed-wiring board. The conditions for curing the adhesive resin composition are usually a range of about 150 to 260°C for about 1 minute to 3 hours, and more preferably a range of about 180 to 210°C for about 30 minutes to 2 hours. The thickness of the dried adhesive layer is appropriately changed as necessary, but is preferably in a range of 5 to 200 um. When the thickness of the adhesive layer is less than 5 µm, the adhesive strength is insufficient. When the thickness of the adhesive layer is 200 um or more, there is a problem that the drying is insufficient, increasing the amount of a residual solvent and thus generating blisters in pressing for producing a printed-wiring board. The drying conditions are not particularly limited, but the proportion of a residual solvent after the drying is preferably 1 mass% or less. When the proportion is more than 1 mass%, there is a problem that the residual solvent is foamed and thus blisters are generated in pressing for a printed-wiring board.

The printed-wiring board according to the present invention comprises as a constituent element a laminate formed of a metal foil for forming a conductor circuit, and a resin base material. The printed-wiring board is produced, for example, by a conventionally known method such as a subtractive method using a metal-clad laminate. The printed-wiring board collectively means, as necessary, a so-called flexible printed circuit (FPC) obtained by partially or entirely covering a conductor circuit, which is formed from a metal foil, with a cover film, screen printing ink, or the like, and a circuit board for flat cables and tape automated bonding (TAB).

The printed-wiring board according to the present invention can have any laminate structure that can be employed as a printed-wiring board. For example, the printed-wiring board can be configured to comprise four layers, i.e., a base-material film layer, a metal foil layer, an adhesive layer, and a cover film layer. For example, the printed-wiring board can be configured to comprise five layers, i.e., a base-material film layer, an adhesive layer, a metal foil layer, an adhesive layer, and a cover film layer.

Further, the printed-wiring board can as necessary be configured to comprise at least two of the above-described printed-wiring boards stacked one on top of another.

The adhesive resin composition according to the present invention can suitably be used as each adhesive layer of the printed-wiring board. Particularly, the adhesive resin composition according to the present invention that is used as an adhesive has high adhesiveness not only to a conventional polyimide, polyester film, or copper foil constituting a printed-wiring board, but also to a low-polarity resin base material such as LCP (liquid crystal polymer) and has excellent solder heat resistance. Therefore, the adhesive resin composition according to the present invention is suitable as an adhesive composition used for coverlay films, laminated sheets, resin-attached copper foils, and bonding sheets.

As to the base-material film of the printed-wiring board according to the present invention, any resin film conventionally used as a base material of a printed-wiring board can be used. Examples of a resin of the base-material film include a polyester resin, a polyamide resin, a polyimide resin, a polyamideimide resin, a liquid crystal polymer, polyphenylene sulfide, syndiotactic polystyrene, a polyolefin-based resin, and a fluorine-based resin.

As to the cover film, any insulating film conventionally known as an insulating film for printed-wiring boards can be used. It is possible to use, for example, films produced from various polymers such as a polyimide, polyester, polyphenylene sulfide, polyethersulfone, polyether ether ketone, an aramid, polycarbonate, polyarylate, and a polyamideimide-based resin. More preferred is a polyimide film.

The printed-wiring board according to the present invention can be produced according to any conventionally known process except for using the above-described materials for layers.

In a preferable embodiment, a semi-product obtained by stacking an adhesive layer on a cover film layer (hereinafter, called a "cover film-side semi-product") is produced. Produced on the other hand is a semi-product obtained by stacking a metal foil layer on a base-material film layer and forming a desired circuit pattern (hereinafter, called a "base-material film-side two-layer semi-product"), or a semi-product obtained by stacking an adhesive layer on a base-material film layer, stacking a metal foil layer on the laminate, and forming a desired circuit pattern (hereinafter, called a "base-material film-side three-layer semi-product") (hereinafter, the base-material film-side two-layer semi-product and a base-material film-side three-layer semi-product are collectively called a "base-material film-side semi-product"). The cover film-side semi-product and the base-material film-side semi-product thus obtained can be bonded with each other so as to give a four-layer or five-layer printed-wiring board.

The base-material film-side semi-product can be obtained by a production method comprising: a step (A) of applying to the metal foil a resin solution to be a base-material film, and initially drying the coating film; and a step (B) of heat-treating and drying a laminated product obtained in the step (A) and comprising the metal foil and the initially dried coating film (hereinafter, called a "heat-treating and solvent removing step").

For the formation of a circuit in the metal foil layer, a conventionally known method can be used. An additive method or a subtractive method may be used. Preferred is a subtractive method.

The obtained base-material film-side semi-product may directly be used for bonding with the cover film-side semi-product, or may have a releasable film bonded therewith and be stored, and then used for bonding with the cover film-side semi-product.

The cover film-side semi-product is produced, for example, by applying an adhesive to a cover film. The applied adhesive can be made to undergo a crosslinking reaction as necessary. In the preferable embodiment, the adhesive layer is semi-cured.

The obtained cover film-side semi-product may directly be used for bonding with the base-material film-side semi-product, or may have a releasable film bonded therewith and be stored, and then used for bonding with the base-material film-side semi-product.

The base-material film-side semi-product and the cover film-side semi-product are each stored, for example, in the form of a roll, and then are bonded with each other so as to produce a printed-wiring board. As a bonding method, any method can be used. The semi-products can be bonded with each other, for example, by pressing or using a roll or the like. The semi-products can also be bonded with each other by heating according to a method of, for example, using a hot press or a heating roll device.

When a reinforcing material, such as a polyimide film, that is soft and can be wound is used to produce a reinforcing material-side semi-product, the production is suitably performed by applying an adhesive to the reinforcing material. When used is a reinforcing plate, such as a metal (SUS, aluminum, and the like) plate, and a plate obtained by curing glass fibers with an epoxy resin, that is hard and cannot be wound, the production is suitably performed by transferring and applying an adhesive having preliminarily been applied to a releasable base material. The applied adhesive can be made to undergo a crosslinking reaction as necessary. In the preferable embodiment, the adhesive layer is semi-cured.

The obtained reinforcing material-side semi-product may directly be used for bonding with the rear surface of a printed-wiring board, or may have a releasable film bonded therewith and be stored, and then used for bonding with the base-material film-side semi-product.

All of the base-material film-side semi-product, the cover film-side semi-product, and the reinforcing material-side semi-product are the laminates, according to the present invention, for printed-wiring boards.

The adhesive resin composition or the adhesive sheet according to the present invention can suitably be used not only for a printed-wiring board but also as each adhesive layer of a laminated film for decorating three-dimensional molded article. The laminated film for decorating three-dimensional molded article according to the present invention is a film used for performing decorative molding on a three-dimensional molded article. That is, the laminated film for decorating three-dimensional molded article is used to impart a design to a molded product by attaching a film having a design to any one of various molded products, or to impart surface protective functions. In the attachment, the film is deformed into a shape along the surface of the three-dimensional shape and closely attached to the surface. Particularly, when used as an adhesive, the adhesive resin composition according to the present invention has high adhesiveness to conventional resin base materials, such as a soft vinyl chloride film, a polycarbonate film, a polyester film, and ABS, constituting a laminated film for decorating three-dimensional molded article, and also has excellent pot life property. Therefore, the adhesive resin composition according to the present invention is suitable as an adhesive resin composition used for a laminated film for decorating three-dimensional molded article for vehicle exterior members such as a side under skirt, a side garnish, and a door mirror, vehicle interior members such as an instrument panel and a door switch panel, and housings of home electric appliances such as a refrigerator, a mobile phone, and a light.

The adhesive resin composition according to the present invention and the adhesive sheet comprising the adhesive resin composition can be used as each adhesive layer of a film for laminating metal can, or a film for laminating metal can. Particularly, when used as an adhesive, the adhesive resin composition according to the present invention has high adhesiveness to a conventional polyester film constituting a film for laminating metal can, and to a metal base material, such as tinplate, tin free steel, and aluminum, constituting a metal can, and also has excellent pot life property. Therefore, the adhesive resin composition according to the present invention is suitable as each adhesive layer of a film for laminating metal can and an adhesive sheet used as a film for laminating metal can.

The adhesive resin composition according to the present invention and a laminate comprising the adhesive resin composition can be used as a packing material. Particularly, when used as an adhesive, the adhesive resin composition according to the present invention has high adhesiveness to plastic films, such as polyethylene terephthalate, polyethylene naphthalate, a vinyl chloride resin, an ABS resin, an acrylic resin, and a polycarbonate resin, generally used for packing materials, and to gas-barrier base materials such as an aluminum foil, and also has excellent pot life property. Therefore, the adhesive resin composition according to the present invention is suitable as each adhesive layer of a packing material and a laminate used as a packing material.

### Examples

As hereunder, the present invention will be more specifically illustrated by referring to Examples although the present invention is not limited to those Examples. Evaluations of various properties were carried out in accordance with the following methods. In the Examples, the unit simply represented by "part" means "part by mass", and "%" means "mass%".

### <Measurement of properties of polyester resin (A)>

### (1) Measurement of resin composition

A sample of the polyester resin (A) was dissolved in deuterated chloroform and subjected to 1H-NMR analysis using nuclear magnetic resonance (NMR) apparatus 400-MR manufactured by Varian Inc. The mole ratio between components was obtained from the ratio of integral values in the analysis.

### (2) Measurement of reduced viscosity (unit: dl/g)

A sample (0.1 g) of the polyester resin (A) was dissolved in 25 cc of a phenol/tetrachloroethane (mass ratio 6/4) mixed solvent, and the reduced viscosity was measured at 30°C.

### (3) Measurement of glass transition temperature (Tg)

The glass transition temperature (Tg) was measured by a differential scanning calorimeter (Seiko Instruments Inc. (SII), DSC-200). A sample (5 mg) of the polyester resin (A) was placed in an aluminum container with a snap-in lid and sealed therein. The container was cooled to - 50°C using liquid nitrogen and next heated to 150°C at 20°C/min. On the endothermic curve obtained through this process, the temperature corresponding to the intersection of the base line before the endothermic peak and the tangent line approaching the endothermic peak was defined as the glass transition temperature (Tg, unit: °C).

### (4) Measurement of acid value

A sample (0.2 g) of the polyester resin (A) was dissolved in 20 ml of chloroform and titrated with a 0.01 N ethanol solution of potassium hydroxide so as to obtain the equivalent per 10⁶ g (eq/ton) of the polyester resin. Phenolphthalein was used as an indicator.

### (5) Measurement of THF-insoluble matter

The amount of THF-insoluble matter when having undergone a heating treatment at 120°C for 15 minutes is obtained by the following equation. In the equation, (X) represents the mass (before immersion in THF) of a sample obtained by preparing methyl ethyl ketone solution (solid content: 20 mass%) of the polyester resin (A), applying the prepared solution onto a copper foil, such that the thickness of the polyester resin (A) after drying is 10 µm, performing heating at 120°C for 15 minutes, and cutting the laminate in the size of length 10 cm and width 2.5 cm, and (Y) represents the mass (after immersion in THF) of the sample having been immersed in 60 ml of THF at 25°C for 1 hour, and then dried at 100°C for 10 minutes. THF-insolube matter (mass%) = [{(Y) - (mass of copper foil)} / {(X) - (mass of copper foil)}] × 100

### <Synthetic Example (a) of polyester resin (A)>

Into a 3-L four-neck flask were charged 580 parts by mass of dimethyl terephthalate, 10 parts by mass of trimellitic anhydride, 60 parts by mass of fumaric acid, 310 parts by mass of ethylene glycol, 380 parts by mass of 1,2-propylene glycol, and 0.5 part by mass (0.03 mol% relative to the total polycarboxylic acid components) of tetra-n-butyl titanate (hereinafter, sometimes abbreviated as TBT) as a catalyst. The resultant mixture was gradually heated to 230°C over 3 hours and thus subjected to a transesterification reaction. Next, 220 parts by mass of adipic acid was charged, and the mixture was gradually heated to 240°C over 1 hour and thus subjected to an esterification reaction. After the reaction, the system was gradually decompressed to 10 mmHg over 1 hour and subjected to vacuum polymerization, and heated to a temperature of 245°C and further subjected to late-stage polymerization under vacuum at 1 mmHg or less for 50 minutes. After having reached a target molecular weight, the system was cooled to 210°C in a nitrogen atmosphere. Next, 20 parts by mass of trimellitic anhydride and 21 parts by mass of ethylene glycol bistrimellitate dianhydride were charged and the system was continuously stirred in a nitrogen atmosphere at 200 to 230°C for 30 minutes. A resultant product was extracted and a polyester resin (Synthetic Example (a)) of the present invention was thus obtained. The obtained polyester resin had a reduced viscosity of 0.30 dl/g, a glass transition temperature (Tg) of 20°C, and an acid value of 300 eq/ton.

### Synthetic Examples (b) to (o)

Polyester resins (Synthetic Examples (b) to (o)) of the present invention were produced by a direct polymerization method in the same manner as in Synthetic Example (a), except that the ingredient composition was changed so that the polyester resins had the resin composition shown in Table 1.

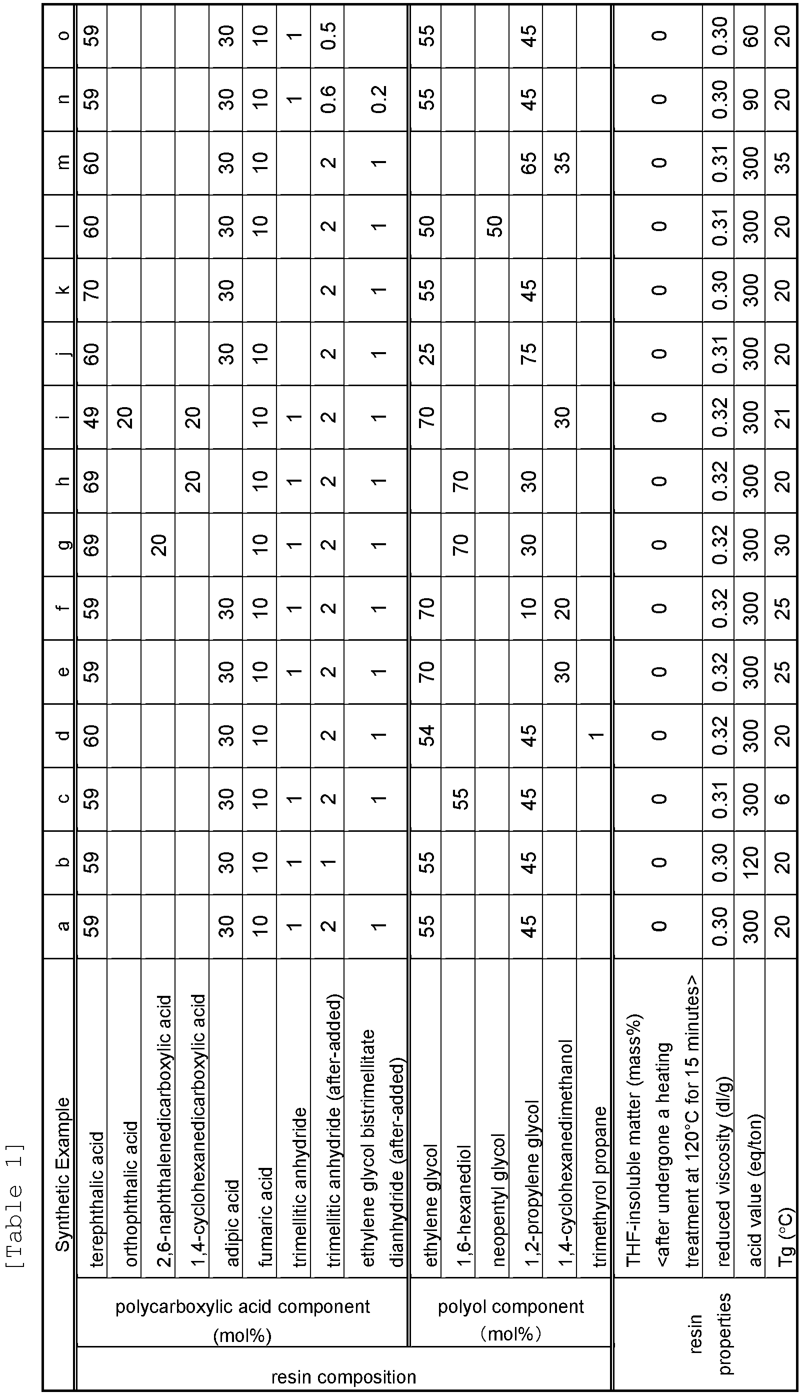

### <Evaluation of properties of adhesive resin composition>

### (1) Measurement of THF-insoluble matter

The amount of THF-insoluble matter when having undergone a heating treatment at 200°C for 1 hour is obtained by the following equation. In the equation, (X) represents the mass (before immersion in THF) of a sample obtained by applying the adhesive resin composition onto a copper foil, such that the thickness after drying is 10 µm, performing heating at 200°C for 1 hour, and cutting the laminate in the size of length 10 cm and width 2.5 cm, and (Y) represents the mass (after immersion in THF) of the sample having been immersed in 60 ml of THF at 25°C for 1 hour, and then dried at 100°C for 10 minutes. THF-insoluble matter (mass%) = [{(Y) - (mass of copper foil)}/{(X) - (mass of copper foil)}] × 100

### (2) Peel strength (adhesiveness to polyimide film or copper-foil base material)

Each of the adhesive resin compositions described later was applied to a 12.5-µm-thick polyimide film (APICAL (registered trade name) manufactured by KANEKA CORPORATION), such that the thickness after drying was 25 um, and the adhesive resin composition was dried at 130°C for 10 minutes. The adhesive layer (B-stage product) thus obtained was bonded with a 12.5-µm-thick polyimide (PI) film or an 18-um-thick rolled copper (Cu) foil (BHY series manufactured by JX Metals Corporation). The bonding was performed by bringing a gloss surface of the rolled copper foil into contact with the adhesive layer, and pressing the foil and the layer at 160°C under a pressure of 40 kgf/cm² for 30 seconds, and the foil and the layer were thus attached to each other. Next, the laminate was heat-treated at 200°C for 1 hour for curing so as to give a sample for evaluating peel strength. The peel strength was measured by performing a 90° peel test, with the film drawn, at 25°C and a tensile speed of 50 mm/min. This test shows adhesive strength at ordinary temperature.

### <Evaluation criteria>

∘∘: 0.8 N/mm or more
o: 0.6 N/mm or more and less than 8.0 N/mm
Δ: 0.4 N/mm or more and less than 0.6 N/mm
×: less than 0.4 N/mm

### (3) Peel strength (adhesiveness to polyester base material, polycarbonate base material, or aluminum-deposited base material)

Each of the adhesive resin compositions described later was applied to a 12.5-µm-thick polyimide film (APICAL (registered trade name) manufactured by KANEKA CORPORATION), such that the thickness after drying was 25 um, and the adhesive resin composition was dried at 200°C for 1 hour. The adhesive layer (B-stage product) thus obtained was bonded with a 25-um-thick polyester (PET) film (E5107 manufactured by TOYOBO CO., LTD.), a 0.125-mm-thick polycarbonate (PC) film (Panlite sheet manufactured by TEIJIN LIMITED), or a 30-um-thick aluminum (Al)-deposited polyester film (manufactured by TOYOBO CO., LTD.). The bonding was performed by bringing an untreated surface of the polycarbonate film, a corona-treated surface of the polyester film, or an aluminum-deposited surface of the aluminum-deposited polyester film into contact with the adhesive layer, and pressing the film and the layer at 120°C under a pressure of 40 kgf/cm² for 30 minutes, and the film and the layer were thus attached to each other so as to give a sample for evaluating peel strength. The peel strength was measured by performing a 90° peel test, with the polyimide film drawn, at 25°C and a tensile speed of 50 mm/min. This test shows adhesive strength at ordinary temperature.

### <Evaluation criteria>

∘∘: 0.8 N/mm or more
o: 0.6 N/mm or more and less than 8.0 N/mm
Δ: 0.4 N/mm or more and less than 0.6 N/mm
×: less than 0.4 N/mm

### (4) Solder heat resistance

A sample was prepared in the same method as in (2) Peel strength or (3) Peel strength described above, and a sample piece (2.0 cm × 2.0 cm) was subjected to an aging treatment at 23°C for 2 days, floated for 10 seconds in a bath of solder melted at 280°C, and checked for the presence or absence of a change in appearance such as blisters.

### <Evaluation criteria>

∘∘: no blister
∘: some blisters
Δ: many blisters
×: blisters and color change

### (5) Pot life property

The pot life property refers to stability of varnish immediately after blending of the adhesive resin composition or after the lapse of a certain time from the blending. Good pot life property refers to varnish that has a small increase in viscosity and can be preserved for a long period. Inferior pot life property refers to varnish that increases the viscosity (is thickened), and, in severe cases, causes a gelation phenomenon, makes the application to a base material difficult, and cannot be preserved for a long period.

Each of the adhesive resin compositions prepared below was measured for solution viscosity at 25°C using a Brookfield type viscometer, and thus an initial solution viscosity ηB0 was obtained. Thereafter, the adhesive resin composition was preserved at 40°C for 7 days, and measured for solution viscosity ηB at 25°C. The ratio in solution viscosity was calculated by the following equation, and the adhesive resin composition was evaluated according to the following criteria. Ratio in solution viscosity = solution viscosity ηB/solution viscosity ηB0

### <Evaluation criteria>

oo: ratio in solution viscosity of 0.5 or more and less than 1.5
o: ratio in solution viscosity of 1.5 or more and less than 2.0
Δ: ratio in solution viscosity of 2.0 or more and less than 3.0
×: ratio in solution viscosity of 3.0 or more, or unmeasurable due to pudding formation

### <Preparation of adhesive resin compositions>

The polyester resin (A) in an amount of 100 parts by mass (solid content) was dissolved in methyl ethyl ketone so as to have an appropriate viscosity for application. The adhesive resin compositions (solid content: about 20 mass%) were obtained according to the blending shown in Tables 2, 3, and 4.

Each of the obtained adhesive resin compositions was evaluated for THF-insoluble matter, adhesiveness to a polyimide film and a copper-foil base material, solder heat resistance, and pot life property. Tables 2 and 3 show the evaluation results. Table 4 shows the evaluation results of adhesiveness to a polyester base material, a polycarbonate base material and an aluminum-deposited base material that are suitably used as a base material of a laminated film for decorating three-dimensional molded article and a packing material, and pot life property.

**[Table 2]**

| item | | | | Example | | | | | | | | | | | | |
|---|---|---|---|---|---|---|---|---|---|---|---|---|---|---|---|---|
| | | | | 1 | 2 | 3 | 4 | 5 | 6 | 7 | 8 | 9 | 10 | 11 | 12 | 13 |
| adhesive resin composition (solid weight ratio) | resin | polyester resin | | a 100 | a 100 | b 100 | c 100 | d 100 | e 100 | f 100 | 9 100 | h 100 | i 100 | j 100 | a 100 | a 100 |
| | catalyst | dodecylbenzenesulfonic acid | | | 0.3 | 0.3 | 0.3 | 0.3 | 0.3 | 0.3 | 0.3 | 0.3 | 0.3 | 0.3 | | |
| | curing agent | HP-7200 ( 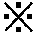 ) | | | | | | | | | | | | | 5 | |
| | | N-3300 ( 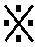 ) | | | | | | | | | | | | | | 5 |
| evaluation | | THF-insoluble matter (mass%) <after treated at 200°C for 1 hour> | | 50 | 90 | 40 | 90 | 90 | 90 | 90 | 80 | 90 | 90 | 40 | 60 | 60 |
| | | PI base material | peel strength | ○○ | ○○ | ○ | ○○ | ○○ | ○○ | ○○ | ○○ | ○○ | ○○ | ○ | Δ | Δ |
| | | | solder heat resistance | ○ | ○○ | ○ | ○○ | ○○ | ○○ | ○○ | ○○ | ○○ | ○○ | ○ | ○ | Δ |
| | | copper-foil base material | peel strength | ○ | ○○ | ○ | ○○ | ○○ | ○○ | ○○ | ○○ | ○○ | ○○ | ○ | Δ | Δ |
| | | | solder heat resistance | ○ | ○○ | ○ | ○○ | ○○ | ○○ | ○○ | ○○ | ○○ | ○○ | ○ | ○ | Δ |
| | | pot life property 40°C × 1 week | | ○○ | ○○ | ○○ | ○○ | ○○ | ○○ | ○○ | ○○ | ○○ | ○○ | ○○ | × | × |

| | | | | | | | | | | | | | | | | |
|---|---|---|---|---|---|---|---|---|---|---|---|---|---|---|---|---|
| ( 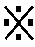 ) HP-7200: dicyclopentadiene type epoxy resin (manufactured by DIC) ( 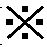 ) N-3300: isocyanate curing agent (manufactured by Covestro) | | | | | | | | | | | | | | | | |

**[Table 3]**

| item | | | | Comparative Example | | | | |
|---|---|---|---|---|---|---|---|---|
| | | | | 1 | 2 | 3 | 4 | 5 |
| adhesive resin composition (solid weight ratio) | resin | polyester resin | | k 100 | l 100 | m 100 | n 100 | o 100 |
| | catalyst | dodecylbenzenesulfonic acid | | | | | 0.3 | 0.3 |
| evaluation | | THF-insoluble matter (mass%) <after treated at 200°C for 1 hour> | | 8 | 5 | 5 | 8 | 3 |
| | | PI base material | peel strength | × | × | × | × | × |
| | | | solder heat resistance | × | × | × | × | × |
| | | copper-foil base material | peel strength | × | × | × | × | × |
| | | | solder heat resistance | × | × | × | × | × |
| | | pot life property 40°C × 1 week | | ○○ | ○○ | ○○ | ○○ | ○○ |

**[Table 4]**

| item | | | | Example | | |
|---|---|---|---|---|---|---|
| | | | | 13 | 14 | 15 |
| adhesive resin composition (solid weight ratio) | resin | polyester resin | | a 100 | a 100 | b 100 |
| | catalyst | dodecylbenzenesulfonic acid | | | 0.3 | 0.3 |
| evaluation | | THF-insoluble matter (mass%) <after treated at 200°C for 1 hour> | | 50 | 90 | 40 |
| | | peel strength | PET base material | ○○ | ○○ | ○ |
| | | | PC base material | ○ | ○○ | ○ |
| | | | Al-deposited base material | ○ | ○○ | ○ |
| | | pot life property 40°C × 1 week | | ○○ | ○○ | ○○ |

As is clear from Tables 2 and 4, the adhesive resin compositions according to the present invention are excellent in all of the adhesiveness (peel strength), and solder heat resistance. Examples 12 and 13 are examples in which a curing agent was blended whereby pot life property was lowered. On the other hand, Comparative Example 1 in which the polyester resin does not contain the unsaturated dicarboxylic acid (d) as polycarboxylic acid components had poor solder heat resistance. Comparative Example 2 in which the polyester resin does not contain the components (b) and (c) as polyol components had bad curing properties, poor adhesiveness (peel strength) and poor solder heat resistance. Comparative Example 3 in which the polyester resin does not contain the component (a) as polyol component had bad curing properties, poor adhesiveness (peel strength) and poor solder heat resistance. Comparative Examples 4 and 5 in which an acid value of the polyester resin is low had bad curing properties, poor adhesiveness (peel strength) and poor solder heat resistance.

### Industrial Applicability

The products according to the present invention are an adhesive resin composition having excellent adhesiveness, and solder heat resistance, and an adhesive sheet, and a laminate comprising the adhesive resin composition. The products according to the present invention are particularly useful as an adhesive for circuit boards represented by a FPC. The products according to the present invention also have adhesiveness to a polyester base material, a polycarbonate base material, and an aluminum-deposited base material, and can be applied as an adhesive for a laminated film for decorating three-dimensional molded article and a packing material.

## Claims

1. An adhesive resin composition containing a polyester resin (A) and satisfying following requirements (i) to (iii).
(i) The polyester resin (A) has an acid value of 100 eq/ton or more.
(ii) The polyester resin (A) contains, as polyol components constituting the polyester resin (A), a diol (a) having two primary hydroxy groups and having no alicyclic structure, and either one or both of a diol (b) having an alicyclic structure and a diol (c) having one primary hydroxy group and one secondary hydroxy group and having no alicyclic structure.
(iii) The polyester resin (A) contains, as polycarboxylic acid components constituting the polyester resin (A), an unsaturated dicarboxylic acid (d).

2. The adhesive resin composition according to claim 1, wherein the polyester resin (A) has a branched structure.

3. The adhesive resin composition according to claim 1 or 2, wherein the adhesive resin composition contains substantially no curing agent.

4. The adhesive resin composition according to claim 1 or 2, wherein the polyester resin (A) contains, as polycarboxylic acid components constituting the polyester resin (A), a polycarboxylic acid having a benzene skeleton, and at least one member selected from the group consisting of an aliphatic polycarboxylic acid, an alicyclic polycarboxylic acid, and a polycarboxylic acid having a naphthalene skeleton.

5. The adhesive resin composition according to claim 1 or 2, wherein the polyester resin (A) contains, as polycarboxylic acid components constituting the polyester resin (A), 5 to 20 mol% of the unsaturated dicarboxylic acid (d).

6. The adhesive resin composition according to claim 1 or 2, wherein the adhesive resin composition further contains at least one catalyst (B).

7. The adhesive resin composition according to claim 1 or 2, wherein the polyester resin (A) exhibits an amount of tetrahydrofuran-insoluble matter of less than 10 mass% when having undergone a heating treatment at 120°C for 15 minutes.

8. A laminate comprising an adhesive layer made from the adhesive resin composition according to claim 1 or 2.

9. An adhesive sheet comprising an adhesive layer made from the adhesive resin composition according to claim 1 or 2.

10. A printed-wiring board comprising the laminate according to claim 8 as a constituent element.

11. A packing material comprising the laminate according to claim 8 as a constituent element.

12. A laminated film for decorating three-dimensional molded article comprising the adhesive sheet according to claim 9 as a constituent element.

13. A film for laminating metal can comprising the adhesive sheet according to claim 9 as a constituent element.
